# FASCICULE DE BREVET EUROPEEN

(11) **EP 3 503 222 B1**
(45) Date de publication et mention de la délivrance du brevet: **12.08.2020**
(21) Numéro de dépôt: 18213127.6
(22) Date de dépôt: 17.12.2018
(51) Int. Cl.: H01L 33/00, H01L 33/32, H01L 33/50, H01L 25/16, H01L 27/15

(54) **PROCÉDÉ DE FABRICATION D'UN DISPOSITIF OPTOÉLECTRONIQUE PAR REPORT D'UNE STRUCTURE DE CONVERSION SUR UNE STRUCTURE D'ÉMISSION**
VERFAHREN ZUR HERSTELLUNG EINER OPTOELEKTRONISCHEN VORRICHTUNG DURCH AUFBRINGEN EINER KONVERTIERUNGSSTRUKTUR AUF EINE EMISSIONSSTRUKTUR
METHOD FOR MANUFACTURING AN OPTOELECTRONIC DEVICE BY TRANSFERRING A CONVERSION STRUCTURE ONTO AN EMISSION STRUCTURE

(30) Priorité: 19.12.2017 FR 1762422
(43) Date de publication de la demande: 26.06.2019
(73) Titulaire: Commissariat à l'Énergie Atomique et aux Énergies Alternatives, 75015 Paris cedex (FR); Thales, 92400 Courbevoie (FR)
(72) Inventeur: DUSSAIGNE, Amélie, 38260 SAINT HILAIRE DE LA COTE (FR); ROBIN, Ivan-Christophe, 38000 GRENOBLE (FR)
(74) Mandataire: GIE Innovation Competence Group

(56) Documents cités:
- EP-A2- 1 132 977
- FR-A1- 3 019 380
- US-A1- 2012 097 921
- US-A1- 2013 049 569

## Description

### DOMAINE TECHNIQUE

Le domaine de l'invention est celui des dispositifs optoélectroniques comportant une structure d'émission d'un premier rayonnement lumineux, par exemple une lumière bleue, et une structure de conversion d'au moins une partie du premier rayonnement lumineux en au moins un deuxième rayonnement lumineux de plus grande longueur d'onde, par exemple une lumière verte ou rouge.

### ÉTAT DE LA TECHNIQUE ANTÉRIEURE

On connaît les dispositifs optoélectroniques comportant une structure d'émission comprenant une ou plusieurs diodes électroluminescentes, celles-ci étant généralement formées d'un empilement de couches semiconductrices adapté à émettre un rayonnement lumineux, par exemple une lumière bleue. Les couches semiconductrices sont habituellement réalisées majoritairement en un composé semiconducteur par exemple III-V, c'est-à-dire comprenant des éléments de la colonne III et de la colonne V du tableau périodique, tel qu'un composé III-N, par exemple le nitrure de gallium (GaN), le nitrure d'indium et de gallium (InGaN) ou le nitrure d'aluminium et de gallium (AlGaN).

Pour émettre un second rayonnement lumineux dans une autre longueur d'onde, le dispositif optoélectronique peut comporter une structure de conversion disposée sur la structure d'émission de manière à recouvrir une surface de transmission de cette dernière. La structure de conversion peut ainsi être adaptée à absorber au moins une partie du premier rayonnement lumineux provenant de la structure d'émission, et à émettre en réponse un second rayonnement lumineux dans une longueur d'onde supérieure à celle du premier rayonnement lumineux initial. A titre d'exemple, la structure de conversion peut absorber d'une lumière bleue émise par la ou les diodes électroluminescentes, et émettre en réponse de la lumière verte.

La demande de brevet WO 2017/001760 A1 décrit un exemple d'un tel dispositif optoélectronique dans lequel la structure de conversion est formée d'une couche photoluminescente comportant des luminophores, ces derniers se présentant sous la forme de poudre ou de grains dispersés dans une matrice liante transparente et optiquement inerte. De tels luminophores peuvent être choisis parmi le grenat d'yttrium et d'aluminium (YAG) et des nanocristaux semiconducteurs formant des boîtes quantiques. Les demandes de brevet EP 1 132 977 A2, US 2013/0049569 A1, FR 3 019 380 A1 et US 2012/0097921 A1 décrivent également des dispositifs optoélectroniques pertinents convertis en longueur d'onde.

Cependant, il existe un besoin de disposer d'un procédé de fabrication d'un dispositif optoélectronique réalisé à base d'un même composé semiconducteur, de sorte que la structure d'émission et la structure de conversion soient toutes deux réalisées à base du même composé semiconducteur, par exemple à base de nitrure de gallium ou en ses alliages, le composé semiconducteur présentant alors une bonne qualité cristalline.

Une approche peut consister à réaliser la structure de conversion par croissance épitaxiale d'un empilement de couches de conversion à base d'InGaN, cet empilement étant adapté à assurer la conversion optique de la lumière émise par la structure d'émission. Cependant, il peut être nécessaire de réaliser une structure de conversion comportant des puits quantiques en InGaN présentant une forte proportion atomique d'indium, par exemple de l'ordre de 25% environ dans le cas de la conversion d'une lumière bleue en lumière verte. Or, le fort désaccord de paramètre de maille entre le GaN et l'InGaN à 25% d'indium est susceptible de provoquer une dégradation de la qualité cristalline de l'InGaN.

De plus, la structure de conversion peut être formée d'une alternance de couches barrière en GaN et de couches formant des puits quantiques en InGaN. L'absorption et l'émission de la lumière émise par la diode électroluminescente sous-jacente étant réalisées dans les couches d'InGaN, il peut être nécessaire de réaliser un grand nombre de puits quantiques d'InGaN pour convertir une partie importante de la lumière bleue émise. Ainsi, pour convertir près de 80% de la lumière bleue, il peut être nécessaire de réaliser au moins 20 puits quantiques d'InGaN d'une épaisseur chacun de 3nm environ. Une telle configuration peut également entraîner une dégradation de la qualité cristalline de l'InGaN contenu dans la structure de conversion.

### EXPOSÉ DE L'INVENTION

L'invention a pour objectif de remédier au moins en partie aux inconvénients de l'art antérieur, et plus particulièrement de proposer un procédé de fabrication d'un dispositif optoélectronique à base de nitrure de gallium, comportant une structure d'émission et une structure de conversion présentant une bonne qualité cristalline.

Pour cela, l'objet de l'invention est un procédé de fabrication d'un dispositif optoélectronique réalisé à base de GaN, comprenant une structure d'émission comportant une zone active adaptée à émettre un premier rayonnement lumineux à la première longueur d'onde. Le procédé comporte les étapes suivantes :
i. réalisation d'une structure de croissance comportant une couche de germination en Inₓ₂Ga₁₋ₓ₂N au moins partiellement relaxé ;
ii. réalisation d'une structure de conversion, par croissance épitaxiale à partir de la structure de croissance, comportant une couche d'émission réalisée à base d'InGaN à partir de la couche de germination et comportant une zone active adaptée à émettre un rayonnement lumineux à une deuxième longueur d'onde supérieure à une première longueur d'onde, et une couche d'absorption réalisée à base d'InGaN à partir de la couche d'émission et adaptée à absorber au moins partiellement le premier rayonnement lumineux ;
iii. report de la structure de conversion sur la structure d'émission de sorte que la couche d'absorption est située entre la structure d'émission et la couche d'émission de la structure de conversion.

Certains aspects préférés mais non limitatifs de ce procédé de fabrication sont les suivants.

La couche d'absorption peut être réalisée en Inₓ₆Ga₁₋ₓ₆N, la proportion atomique d'indium x6 étant choisie pour que la couche d'absorption présente une énergie de bandes interdites Eg(Inₓ₆Ga₁₋ₓ₆N) inférieure à h.c/λ1, h étant la constante de Boltzmann et c la célérité de la lumière, λ₁ étant la première longueur d'onde.

La couche d'émission peut former une zone active comportant une alternance de couches barrières en Inₓ₄Ga₁₋ₓ₄N tel que x4 soit supérieur ou égal à x2, et d'au moins une couche émissive en Inₓ₅Ga₁₋ₓ₅N formant un puits quantique intercalé entre deux couches barrières, la proportion atomique d'indium x4 des couches barrières étant choisie pour qu'elles présentent une énergie de bandes interdites Eg(Inₓ₄Ga₁₋ₓ₄N) inférieure à h.c/λ₁.

La zone active de la structure d'émission peut comporter au moins un puits quantique en Inₓ₁Ga₁₋ₓ₁N, la proportion atomique d'indium x4 étant supérieure ou égale à x1 et inférieure à x5.

La zone active de la structure d'émission peut comporter au moins un puits quantique en Inₓ₁Ga₁₋ₓ₁N, la couche d'absorption étant réalisée en Inₓ₆Ga₁₋ₓ₆N avec une proportion atomique d'indium x6 supérieure ou égale à x1 et inférieure à x5.

La proportion atomique d'indium x5 peut être comprise entre 22% et 30%.

La couche de germination peut être réalisée en Inₓ₂Ga₁₋ₓ₂N avec une proportion atomique d'indium x2 comprise entre 1% et 14%.

La couche de germination peut présenter un paramètre de maille égal à sa valeur naturelle à 0,75% près en compression et à 0,15% près en tension, et de préférence égal à sa valeur naturelle à ±0,03% près.

La couche d'émission peut former une zone active comportant une alternance de couches barrières en Inₓ₄Ga₁₋ₓ₄N tel que x4 soit supérieur ou égal à x2, et d'au moins une couche émissive en Inₓ₅Ga₁₋ₓ₅N formant un puits quantique intercalé entre deux couches barrières, dans lequel l'étape ii de réalisation de la structure de conversion comporte la réalisation d'une couche tampon, réalisée à base d'Inₓ₃Ga₁₋ₓ₃N à partir de la couche de germination, configurée pour permettre une adaptation de maille entre l'Inₓ₂Gₐ₁₋ₓ₂N de la couche de germination et l'Inₓ₄Ga₁₋ₓ₄N d'une couche barrière de la couche d'émission avec laquelle elle est destinée à être en contact.

La couche tampon peut être formée d'une alternance de couches à base de GaN et de couches en Inₓ₃'Ga_{1-x3'}N.

Les couches en In_{x3'}Ga_{1-x3'}N peuvent présenter une proportion atomique d'indium x3' supérieure ou égale à x4.

La couche tampon peut être réalisée en Inₓ₃Ga₁₋ₓ₃N avec une proportion atomique d'indium x3 qui augmente entre la valeur x2 à l'interface avec la couche de germination et la valeur x4 à l'interface avec la couche barrière de la couche d'émission au contact de la couche tampon.

La structure de croissance peut être formée d'un empilement d'une couche support, d'une couche de liaison et de la couche de germination.

La couche de germination peut être formée par report sur la couche de liaison d'une couche en Inₓ₂Ga₁₋ₓ₂N préalablement épitaxiée à partir d'un substrat de croissance, suivie d'une séparation de la couche en Inₓ₂Ga₁₋ₓ₂N en deux parties au niveau d'une zone fragilisée suite à une implantation ionique préalable, la partie au contact de la couche de liaison formant la couche de germination.

Le procédé peut comporter, à la suite de l'étape iii de report, la suppression de la couche support et de la couche de liaison de la structure de croissance.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1F sont des vues en coupe qui illustrent schématiquement différentes étapes d'un procédé de fabrication d'un dispositif optoélectronique selon un mode de réalisation ;
les figures 2A et 2B sont des vues en coupe, schématiques et partielles, de dispositifs optoélectroniques obtenus par le procédé de fabrication selon des variantes de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près. Par ailleurs, l'expression « comportant un » doit être comprise comme « comportant au moins un », sauf indication contraire.

L'invention porte sur un procédé de fabrication d'un dispositif optoélectronique 1 comprenant :
- une structure d'émission 10 formée d'au moins une diode électroluminescente adaptée à émettre un premier rayonnement lumineux à une première longueur d'onde λ₁, par exemple une lumière bleue, et
- une structure de conversion 30 adaptée à absorber de la lumière émise par la diode électroluminescente de la structure d'émission 10 et à émettre en réponse au moins un deuxième rayonnement lumineux à une deuxième longueur d'onde λ₂, celle-ci étant alors supérieure à λ₁, par exemple une lumière verte ou rouge.

D'une manière générale, un rayonnement lumineux dans le bleu correspond à un spectre comportant un pic d'intensité à une longueur d'onde comprise entre 440nm à 490nm environ, le vert à une longueur d'onde comprise entre 495nm et 560nm environ, et le rouge à une longueur d'onde comprise entre 600nm et 650nm environ.

Le dispositif optoélectronique 1 est réalisé à base d'un même composé semiconducteur cristallin, et plus précisément à base de nitrure de gallium GaN. Autrement dit, la structure d'émission 10 et la structure de conversion 30 sont réalisées à base de GaN, c'est-à-dire qu'elles sont réalisées majoritairement en GaN ou en l'un de ses alliages.

La structure d'émission 10 peut être qualifiée d'active dans le sens où elle est adaptée à émettre un premier rayonnement lumineux, par exemple une lumière bleue, par suite de la polarisation électrique de la ou des diodes électroluminescentes. La structure de conversion 30 peut être qualifiée de passive dans le sens où elle est adaptée à émettre un deuxième rayonnement lumineux en réponse à l'absorption d'au moins une partie du premier rayonnement lumineux provenant de la structure d'émission 10. La structure de conversion 30 n'est ainsi pas polarisée électriquement au moyen d'électrodes.

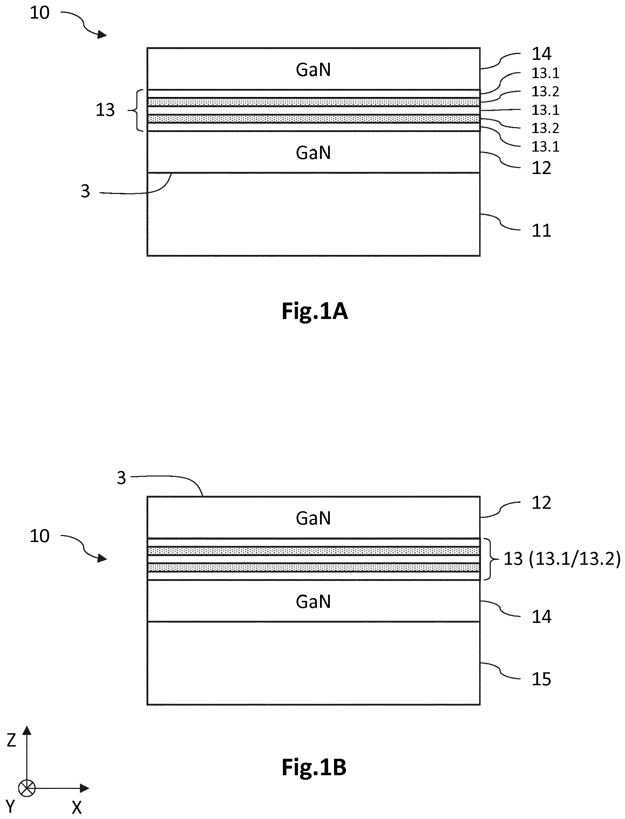

Les figures 1A à 1F sont des vues en coupe transversale illustrant schématiquement différentes étapes d'un procédé de fabrication d'un dispositif optoélectronique 1 selon un mode de réalisation.

On définit ici et pour la suite de la description un repère direct tridimensionnel orthogonal (X,Y,Z), où les axes X et Y forment un plan parallèle aux plans principaux suivant lesquels s'étendent la structure d'émission 10 et la structure de conversion 30, et où l'axe Z est orienté de manière sensiblement orthogonale au plan XY suivant une direction d'émission lumineuse du dispositif optoélectronique 1.

Les figures 1A et 1B illustrent une étape préalable de réalisation d'une structure d'émission 10 comportant au moins une diode électroluminescente reposant sur une puce de commande 15.

La structure d'émission 10 comporte un empilement de couches semiconductrices 12, 13, 14 formant une ou plusieurs diodes électroluminescentes, cet empilement reposant sur une puce de commande 15. Une seule diode électroluminescente est ici représentée.

Dans un premier temps (fig.iA), on réalise par croissance épitaxiale l'empilement de couches semiconductrices 12, 13, 14 formant une ou plusieurs diodes électroluminescentes à partir d'un substrat de croissance 11. Le substrat de croissance 11 peut être en un matériau isolant, par exemple en saphir, ou en matériau semiconducteur, par exemple en silicium ou à base d'un composé III-V ou II-VI. Il peut s'agir un substrat massif (*bulk,* en anglais) ou un empilement de couches distinctes tel qu'un substrat SOI (pour *Silicon-On-Insulator,* en anglais)

La ou les diodes électroluminescentes sont donc formées d'un empilement de couches semiconductrices 12, 13, 14 réalisées à base de GaN, c'est-à-dire réalisées majoritairement en GaN ou en ses alliages. Elle comporte ainsi une première couche 12 dopée d'un premier type de conductivité, par exemple du GaN dopé de type n, et une deuxième couche 14 dopée d'un second type de conductivité opposé au premier type, par exemple du GaN dopé de type p, entre lesquelles se situe une zone active 13. La zone active 13 est la région de la diode électroluminescente à partir de laquelle le premier rayonnement lumineux de longueur d'onde λ₁ est majoritairement émis. La face de la première couche 12 dopée n, opposée à la zone active 13, est destinée à former une surface de transmission 3 au travers de laquelle est émis le premier rayonnement lumineux. Sur cette face 3 reposera la structure de conversion 30. A titre illustratif, la couche 14 dopée p peut présenter une épaisseur comprise entre 50nm et 20µm et la couche 12 dopée n peut présenter une épaisseur comprise entre 0,1µm et 20µm. La couche 14 dopée p peut comporter une couche intercalaire de blocage d'électrons (non représentée) située à l'interface avec la zone active 13. Les couches dopées 12, 14 peuvent présenter une densité de dopants homogène ou variable suivant l'épaisseur des couches.

La zone active 13 est formée d'un empilement de couches barrières 13.1 et d'au moins une couche émissive 13.2 formant un puits quantique. De préférence, la zone active 13 comporte plusieurs puits quantiques 13.2, chacun étant situé entre deux couches barrières 13.1. La zone active 13 est également réalisée à base de GaN. Ainsi, les couches 13.2 formant les puits quantiques sont réalisées de préférence en Inₓ₁Ga₁₋ₓ₁N avec une proportion atomique d'indium x1 comprise, par exemple, entre 9% et 18% environ lorsque le premier rayonnement lumineux émis est une lumière bleue, de préférence égale à 16% environ. Elles peuvent présenter une épaisseur comprise entre 1nm et 7nm environ. Les couches barrières 13.1 peuvent être réalisées en GaN, voire en InGaN avec une proportion atomique d'indium inférieure à x1, et peuvent présenter une épaisseur comprise entre 1nm et 50nm environ. Les couches 13.1, 13.2 de la zone active 13 sont de préférence non intentionnellement dopées. La zone active 13 peut présenter une épaisseur comprise entre 10nm et 500nm environ.

L'empilement des couches semiconductrices formant la ou les diodes électroluminescentes peut être réalisé par des techniques d'épitaxie classiques telles que le dépôt chimique en phase vapeur (CVD pour *Chemical Vapor Deposition,* en anglais) par exemple aux organométalliques (MOCVD, pour *Metal-Organic Chemical Vapor Deposition*), l'épitaxie par jets moléculaires (MBE, pour *Molecular Beam Epitaxy*), l'épitaxie en phase vapeur aux hydrures (HVPE, pour *Hydride Vapor Phase Epitaxy*), l'épitaxie par couche atomique (ALE, pour *Atomic Layer Epitaxy*), le dépôt par couche atomique (ALD, pour *Atomic Layer Deposition*), voire par évaporation ou pulvérisation cathodique (*sputtering,* en anglais).

L'empilement de couches semiconductrices comporte en outre des portions électriquement conductrices (non représentées) adaptées à assurer la polarisation électrique de la ou des diodes électroluminescentes.

Dans un deuxième temps (fig.iB), on peut réaliser le report de l'empilement de couches semiconductrices 12, 13, 14 sur une puce de commande 15, suivi de la suppression du substrat de croissance 11. La puce de commande 15 comporte des éléments de connexion (non représentés) permettant de polariser la ou les diodes électroluminescentes. Elle peut comporter des éléments électroniques, de type transistors, assurant la commande d'émission de la diode électroluminescente. Alternativement, elle peut être un composant passif ne comportant essentiellement que des lignes de connexion électriques s'étendant jusqu'à des éléments électroniques déportés.

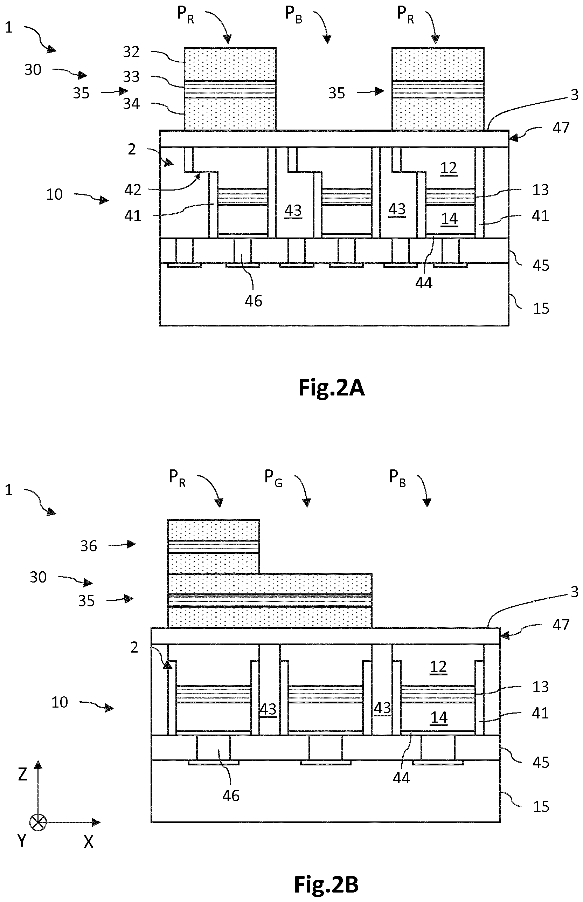

Comme décrit plus loin en référence aux fig.2A et 2B, des étapes de structuration de l'empilement des couches semiconductrices 12, 13, 14 peuvent être effectuées de manière à réaliser une pluralité de diodes électroluminescentes distinctes les unes des autres. Cette phase de structuration comporte des étapes de dépôt de couches diélectriques et de couches électriquement conductrices, ainsi que des étapes de photolithographie et gravure. Elles peuvent être effectuées avant ou après l'étape de report sur la puce de commande. Les diodes électroluminescentes peuvent présenter une structure identique ou similaire à celle décrite dans la publication de Fan et al intitulée III-nitride micro-emetter arrays development and applications, J. Phys. D: Appl. Phys., 41 (2008) 094001. En variante, et de manière préférée, elles peuvent être identiques ou similaires à la structure décrite dans la demande de brevet EP 2 960 940 A1.

On obtient ainsi une structure d'émission 10 adaptée à émettre un premier rayonnement lumineux, présentant une face d'émission 3 sensiblement plane, destinée à recevoir la structure de conversion 30. La face de transmission 3 est ici formée par une face de l'une des couches dopées, ici la couche dopée 12 de type n. En variante, elle peut être formée par une face d'une couche ou d'une plaque intercalaire réalisée en un matériau diélectrique, transparent et optiquement inerte vis-à-vis du premier rayonnement lumineux, par exemple un oxyde ou un nitrure de silicium, voire du verre, pyrex ou autre. L'épaisseur de cette couche intercalaire peut présenter une épaisseur comprise entre 500nm et 50µm, par exemple comprise entre µm et 5µm.

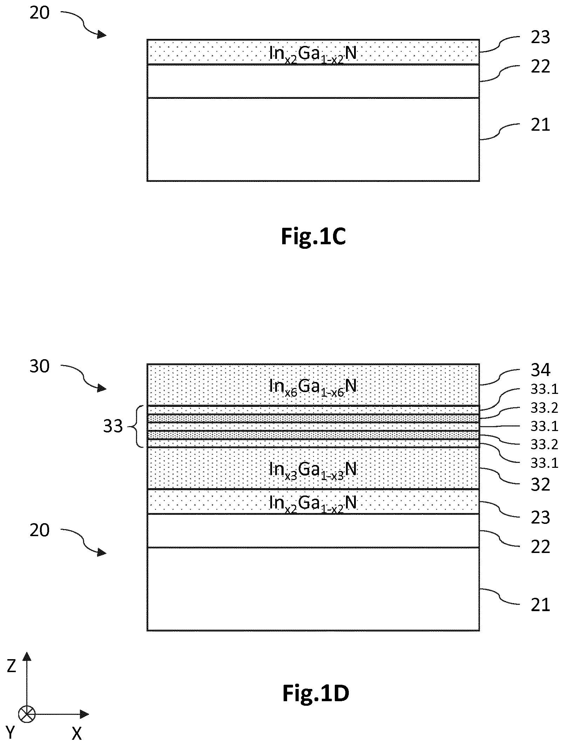

La figure 1C illustre une étape de réalisation d'une structure de croissance 20. Celle-ci comporte une couche de germination 23, ou couche de nucléation, réalisée en Inₓ₂Ga₁₋ₓ₂N au moins partiellement relaxé, c'est-à-dire partiellement relaxé ou de préférence relaxé. Par InGaN partiellement relaxé, on entend que le composé présente un paramètre de maille égal à sa valeur naturelle à 0,75% près en compression et à 0,15% près en tension. Par InGaN relaxé, on entend que son paramètre de maille est égal à sa valeur naturelle à ±0,03% près. La valeur naturelle du paramètre de maille est la valeur lorsque le composé ne subit pas de contraintes mécaniques, notamment en tension ou en compression. Le paramètre de maille peut être mesuré par diffraction aux rayons X en faisant une cartographie du réseau réciproque. A titre d'exemple, pour de l'InGaN à 8% d'indium, le paramètre de maille naturel est égal à 3,215Å. Il est dit partiellement relaxé si le paramètre de maille est compris entre 3,191Å et 3,220Å et est considéré comme étant relaxé si le paramètre de maille est égal à 3,215Å à ±0,001Å près.

La couche de germination 23 est de préférence la couche supérieure d'un empilement de couches distinctes 21, 22, 23. Elle peut ainsi être une structure dite InGaNoS (pour *InGaN-on-Substrate,* en anglais) formée d'une couche support 21, par exemple un substrat en saphir (Al₂O₃) ou en silicium (Si), d'une couche de liaison 22 en un matériau diélectrique, et de la couche de germination 23 en Inₓ₂Ga₁₋ₓ₂N au moins partiellement relaxé et de préférence relaxé.

Cette structure de croissance 20 peut être obtenue par un procédé de fabrication décrit notamment dans la demande de brevet EP 2 330 697 A1. Ainsi, on effectue tout d'abord la croissance épitaxiale d'une couche d'Inₓ₂Gₐ₁₋ₓ₂N à partir d'un substrat temporaire de croissance, par exemple une couche de GaN formée sur un substrat de saphir. La couche d'Inₓ₂Gₐ₁₋ₓ₂N peut présenter une épaisseur inférieure à son épaisseur critique à partir de laquelle a lieu une relaxation plastique des contraintes mécaniques, pour limiter la formation de défauts structuraux. Le caractère relaxé de la couche d'Inₓ₂Gₐ₁₋ₓ₂N peut être amélioré au moyen de recuits successifs. En variante, la couche d'Inₓ₂Gₐ₁₋ₓ₂N peut être une couche dite épaisse dans la mesure où elle présente une épaisseur supérieure à son épaisseur critique. On effectue ensuite une implantation d'ions H⁺ (technologie Smart Cut™) dans la couche épaisse d'Inₓ₂Ga₁₋ₓ₂N pour former une zone fragilisée facilitant le transfert sur la couche support. On procède ensuite à la solidarisation de la couche épaisse d'Inₓ₂Ga₁₋ₓ₂N à une couche de liaison 22 en un matériau diélectrique, par exemple un oxyde ou un nitrure de silicium, préalablement déposé sur la couche support 21, celle-ci pouvant être un substrat en saphir. On supprime le substrat de croissance et on sépare enfin la couche épaisse d'Inₓ₂Gₐ₁₋ₓ₂N en deux parties au niveau de la zone fragilisée par l'implantation d'ions H⁺. On obtient ainsi une structure de croissance 20 formée d'un empilement comportant la couche support 21, la couche de liaison 22 et la couche de germination 23 en Inₓ₂GaN au moins partiellement relaxé. Celle-ci peut présenter une épaisseur par exemple comprise entre 5nm et 500nm. De par sa structure partiellement relaxée et de préférence relaxée, elle présente une densité particulièrement faible de défauts structuraux tels que les dislocations de désaccord de maille. Dans le cas de la conversion d'une lumière bleue en une lumière verte, la proportion atomique d'indium x2 peut être comprise entre 1% et 14%, et de préférence comprise entre 1% et 8%.

La figure 1D illustre une étape de réalisation de la structure de conversion 30, par croissance épitaxiale à partir de la structure de croissance 20. La croissance épitaxiale peut être mise en œuvre par l'une des techniques citées précédemment.

La structure de conversion 30 comporte un empilement de couches semiconductrices 32, 33, 34 réalisées à base de GaN, et plus précisément à base d'InGaN, à savoir une couche tampon 32 facultative mais avantageuse, une couche d'émission 33, et une couche d'absorption 34.

Dans un premier temps, on forme la couche tampon 32 (*buffer,* en anglais), par épitaxie à partir de la couche de germination 23 en Inₓ₂Ga₁₋ₓ₂N. Cette couche tampon 32 est configurée pour permettre une adaptation du paramètre de maille entre la couche de germination 23 et la couche d'émission 33, et plus précisément avec une première couche barrière 33.1 en Inₓ₄Ga₁₋ₓ₄N avec laquelle elle est en contact. Cette couche tampon 32 peut être omise dans le cas où la couche de germination 23 en Inₓ₂Ga₁₋ₓ₂N et la première couche barrière 33.1 en Inₓ₄Ga₁₋ₓ₄N présentent la même valeur de proportion atomique d'indium x2=x4, ce qui se traduit par la même valeur de paramètre de maille. Elle est présente, de préférence, lorsque ces couches présentent des paramètres de maille différents, notamment lorsque x2 est inférieur à x4. A titre d'exemple, la couche de germination 23 peut être réalisée en Inₓ₂Ga₁₋ₓ₂N avec x2=8% environ et la première couche barrière 33.1 en Inₓ₄Ga₁₋ₓ₄N avec x4=17% environ. Dans ce cas, la couche tampon 32 d'adaptation de maille est avantageusement réalisée.

La couche tampon 32 est réalisée à base d'Inₓ₃Ga₁₋ₓ₃N avec une proportion atomique d'indium x₃, cette valeur pouvant être constante ou variable suivant l'épaisseur de la couche. Elle peut ainsi être localement comprise, suivant l'épaisseur de la couche, entre x2 et x4 environ. Elle peut présenter une épaisseur comprise entre 5nm et 10µm.

Selon une variante, elle peut ainsi être réalisée en Inₓ₃Ga₁₋ₓ₃N avec une proportion atomique d'indium x₃ qui varie suivant son épaisseur, et plus précisément qui augmente entre une valeur basse égale à la proportion atomique d'indium x2 à l'interface avec la couche de germination 23 en Inₓ₂Ga₁₋ₓ₂N, et une valeur haute égale à la proportion atomique d'indium x4 à l'interface avec la première couche barrière 33.1 en Inₓ₄Ga₁₋ₓ₄N de la couche d'émission 33. Elle peut présenter une épaisseur comprise entre 5nm et 10µm. Dans le cas de la conversion d'une lumière bleue en lumière verte, elle peut ainsi présenter une proportion atomique d'indium x3 variant continûment entre 8% de l'Inₓ₂Gₐ₁₋ₓ₂N et 17% de l'Inₓ₄Ga₁₋ₓ₄N.

Selon une autre variante (non représentée), la couche tampon 32 peut être formée d'un empilement de couches semiconductrices dans lequel alternent des couches minces de (Al,Ga)N et des couches d'Inₓ₃Ga₁₋ₓ₃N. La proportion atomique d'indium x3 peut être égale à la valeur x4 à l'interface avec l'Inₓ₄Ga₁₋ₓ₄N de la première couche barrière 33.1, par exemple 17% dans le cas de la conversion de la lumière bleue en lumière rouge. La proportion atomique d'indium x3 peut être identique pour toutes les couches d'Inₓ₃Ga₁₋ₓ₃N, ou peut varier suivant l'épaisseur entre une valeur basse égale à x2 environ et une valeur haute égale à x4 environ, comme mentionné précédemment. Les couches de (Al,Ga)N peuvent présenter une épaisseur comprise entre 0.25nm et 50nm, de préférence égale à 2nm, et les couches d'Inₓ₃Ga₁₋ₓ₃N peuvent présenter une épaisseur comprise entre 2.5nm et 100nm, par exemple égale à 20nm. La couche tampon 32 peut présenter une épaisseur totale comprise entre 10nm et 10µm, par exemple égale à 500nm.

Selon une autre variante (non représentée), la couche tampon 32 peut présenter une structure de super-réseau et être formée d'un empilement de couches semiconductrices dans lequel alternent des couches d'In_{x3'}Ga_{1-x3'}N et des couches à base de (Ga,In)N, la proportion atomique x3' étant adaptée pour que la couche tampon 32 corresponde à une couche équivalente réalisée en Inₓ₃Ga₁₋ₓ₃N avec une proportion atomique d'indium x3 moyenne égale à x4 environ. Les couches d'In_{x3'}Ga_{1-x3'}N présentent de préférence une proportion atomique d'indium x3' qui peut être identique pour toutes les couches d'In_{x3'}Ga_{1-x3'}N. Les couches à base de (Ga,In)N, peuvent être réalisées en GaN ou en InGaN avec une proportion atomique d'indium inférieure à celle de l'In_{x3'}Ga_{1-x3'}N et présenter une épaisseur de l'ordre de 0.25nm à 10nm, de préférence égale à 2nm. Les couches d'In_{x3'}Ga_{1-x3'}N présentent de préférence une épaisseur de même valeur voire inférieure à celle des couches de GaN, par exemple égale à la moitié. Ainsi, les couches d'Inₓ₃'Ga₁₋ₓ₃'N peuvent présenter une forte concentration d'indium mais leur faible épaisseur permet d'éviter la relaxation plastique susceptible de former des défauts structuraux. A titre d'exemple, les couches de GaN et d'In_{x3'}Ga_{1-x3'}N présentent une même épaisseur, par exemple égale à 2nm, et la proportion atomique d'indium x3' est égale à deux fois x4, de manière à obtenir une couche tampon 32 correspondant à une couche équivalente réalisée en Inₓ₃Ga₁₋ₓ₃N avec x3=x4.

Dans un deuxième temps, on réalise la couche d'émission 33, par épitaxie à partir de la couche tampon 32 lorsqu'elle est présente, ou à partir de la couche de germination 23 le cas échéant. La couche d'émission 33 forme la zone active de la structure de conversion 30 dans le sens où elle correspond à la région à partir de laquelle le deuxième rayonnement lumineux est majoritairement émis en réponse à l'absorption du premier rayonnement lumineux. Elle est formée d'un empilement de couches barrières 33.1 en Inₓ₄Ga₁₋ₓ₄N et d'au moins une couche émissive 33.2 formant un puits quantique en Inₓ₅Ga₁₋ₓ₅N. De préférence, elle comporte plusieurs puits quantiques 33.2, chacun étant situé entre deux couches barrières 33.1. Les couches 33.1, 33.2 de la zone active 33 sont de préférence non intentionnellement dopées.

Les couches barrières 33.1 sont réalisées en Inₓ₄Ga₁₋ₓ₄N avec une proportion atomique d'indium x4 inférieure à x5. De préférence, la proportion atomique d'indium x4 est choisie pour que les couches barrières 33.1 présentent une énergie de bandes interdites Eg(Inₓ₄Ga₁₋ₓ₄N) inférieure à h.c/λ₁, permettant ainsi d'absorber également au moins une partie du premier rayonnement lumineux. Elle peut ainsi, dans le cas de la conversion d'une lumière bleue en lumière verte, être supérieure ou égale à la proportion atomique x1 des couches émissives 13.2 de la structure d'émission 10, par exemple être égale à 17% environ, tout en étant inférieure à la proportion atomique d'indium x5 de l'Inₓ₅Ga₁₋ₓ₅N des puits quantiques 33.2 de la couche d'émission 33. Elles peuvent présenter une épaisseur comprise entre 1nm et 50nm environ. Une première couche barrière 33.1 est au contact de la couche tampon 32 lorsqu'elle est présente, ou le cas échéant de la couche de germination 23.

Les puits quantiques 33.2 sont réalisés en Inₓ₅Ga₁₋ₓ₅N avec une proportion atomique d'indium x5 comprise, par exemple, entre 22% et 30% environ lorsque le deuxième rayonnement lumineux émis est une lumière verte, et de préférence égale à 25% environ. Elle peut être comprise entre 30% et 40% environ pour une émission dans le rouge, par exemple être égale à 35% environ. Les couches 33.2 formant les puits quantiques peuvent présenter une épaisseur comprise entre 1nm et 8nm environ.

Dans un troisième temps, on réalise la couche d'absorption 34 par épitaxie à partir de la couche d'émission 33, et plus précisément à partir d'une dernière couche barrière 33.1 située du côté opposé à la première couche barrière 33.1 qui est au contact de la couche tampon 32. Elle est destinée à permettre l'absorption d'au moins une partie du premier rayonnement lumineux émis par la structure d'émission 10. Lors de l'absorption dans la couche d'absorption 34, une paire électron-trou est formée et ces porteurs de charge peuvent ensuite se recombiner de manière radiative dans un puits quantique de la couche d'émission 33. La couche d'absorption 34 est réalisée à base de GaN et plus précisément est réalisée en Inₓ₆Ga₁₋ₓ₆N avec une proportion atomique d'indium x6 de préférence homogène au sein de la couche. Elle présente une épaisseur comprise entre 10nm et 10µm, et de préférence supérieure à 100nm pour contribuer à absorber efficacement le premier rayonnement lumineux. Dans le cas de la conversion d'une lumière bleue en lumière verte, la couche d'absorption 34 présente une proportion atomique d'indium x6 choisie pour qu'elle présente une énergie de bandes interdites Eg(Inₓ₆Ga₁₋ₓ₆N) inférieure à h.c/λ₁, permettant ainsi d'absorber au moins en partie la lumière bleue émise par la structure d'émission 10. Elle peut ainsi être supérieure ou égale à la proportion atomique x1 des couches émissives 13.2 de la structure d'émission 10, par exemple être égale à 17% et être inférieure à la proportion atomique d'indium x5 de l'Inₓ₅Ga₁₋ₓ₅N des puits quantiques 33.2 de la couche d'émission 33.

On obtient ainsi une structure d'émission 30 réalisée majoritairement en InGaN, comportant une couche d'émission 33 et une couche d'absorption 34, et le cas échéant une couche tampon 32 au contact de la face de la couche d'émission 33 opposée à la couche d'absorption 34. Les couches barrières 33.1 de la couche d'émission 33 sont avantageusement adaptées à absorber au moins une partie du premier rayonnement lumineux.

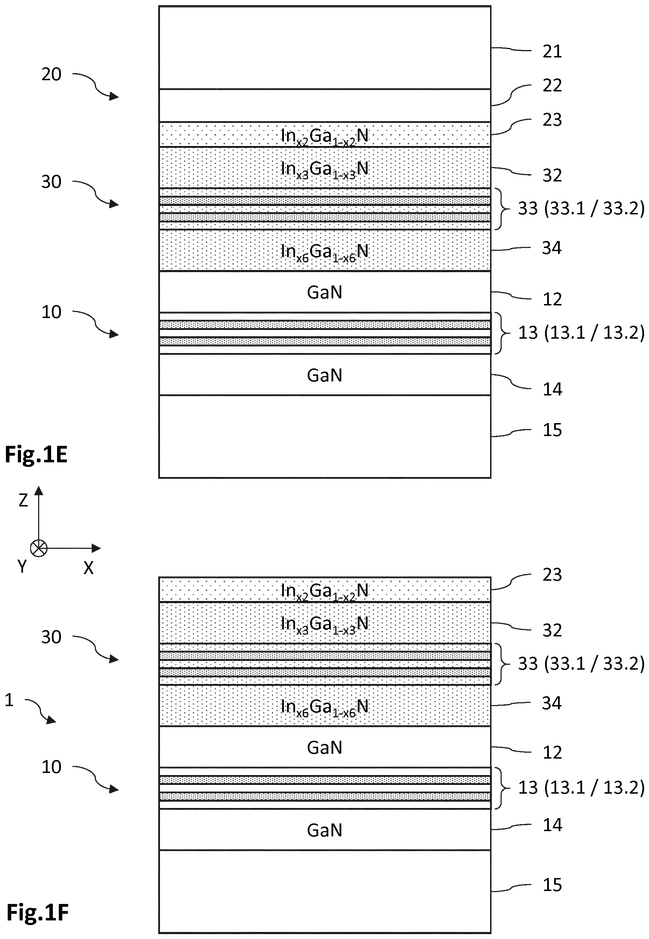

La figure 1E illustre une étape de report de la structure de conversion 30 sur la structure d'émission 10. Plus précisément, la structure de conversion 30 est assemblée à la structure d'émission 10 de sorte que la face libre de la couche d'absorption 34 soit fixée à la face de transmission 3 de la structure d'émission 10. La face libre 3 de la structure d'émission 10 peut être celle de la couche dopée (comme représenté sur la fig.iE) ou celle d'une couche intercalaire (non représentée). Ainsi, la couche d'absorption 34 est située entre la structure d'émission 10 d'une part, et la couche d'émission 33 d'autre part. Cette étape peut être réalisée par l'une des techniques classiques de report et d'assemblage, par exemple par collage des deux structures 10, 30 à l'aide d'une colle époxy, celle-ci étant transparente au premier rayonnement lumineux et avantageusement électriquement isolante. D'autres techniques sont possibles, comme par exemple le collage direct, entre autres.

La figure 1F illustre une étape de suppression de la couche support 21 et de la couche de liaison 22 de la structure de croissance 20. Cette étape de suppression peut être effectuée par meulage et/ou gravure, voire au moyen d'un laser par un procédé de type laser lift-off. La couche de germination 23 en Inₓ₂Ga₁₋ₓ₂N au moins partiellement relaxé peut être gardée (comme représenté sur la fig.iF) ou être supprimée.

Ainsi, le procédé de fabrication permet d'obtenir un dispositif optoélectronique 1 à base du même composé semiconducteur, à savoir ici en nitrure de gallium et en ses alliages, comportant plus précisément une structure d'émission 10 réalisée majoritairement en GaN et une structure de conversion 30 réalisée majoritairement en InGaN. Ce dispositif optoélectronique 1 permet donc l'émission d'au moins un deuxième rayonnement lumineux de longueur d'onde λ₂, par exemple une lumière verte ou rouge, en réponse à l'absorption d'un premier rayonnement lumineux d'excitation de plus faible longueur d'onde λ₁, par exemple une lumière bleue.

La structure de conversion 30 à base d'InGaN peut ainsi comporter des puits quantiques 33.2 à forte proportion atomique d'indium, permettant ainsi une conversion dans le vert ou le rouge, tout en présentant une bonne qualité cristalline. Ces caractéristiques structurales sont possibles par l'utilisation d'une couche de germination 23 en InGaN au moins partiellement relaxé, ici obtenue de préférence par la technologie InGaNoS (pour *InGaN-on-Substrate,* en anglais). En effet, il apparaît qu'une couche de germination 23 en InGaN au moins partiellement relaxé permet d'incorporer davantage d'indium dans les couches épitaxiées 32, 33, 34 à base d'InGaN tout en minimisant la présence des défauts structuraux tels que les dislocations de désaccord de maille. Les propriétés optiques du dispositif optoélectronique 1, sont ainsi améliorées.

Il est alors possible d'améliorer le taux de conversion, c'est-à-dire le nombre de photons émis du deuxième rayonnement lumineux par nombre de photons émis du premier rayonnement lumineux, en réalisant des puits quantiques 33.2 de la structure de conversion 30 à bon rendement quantique interne, et notamment des couches barrières 33.1 qui permettent également d'absorber le premier rayonnement lumineux, en plus de la couche d'absorption 34.

A titre d'exemple, dans le cas d'une conversion d'une lumière bleue en lumière verte, le dispositif optoélectronique 1 émet en direction de la structure de conversion 30 une lumière bleue au niveau des couches émissives 13.2 en Inₓ₁Ga₁₋ₓ₁N avec x1 égal à 15% environ. La structure de conversion 30 absorbe au moins une partie de la lumière bleue, dans la couche d'absorption 34 réalisée en Inₓ₆Ga₁₋ₓ₆N avec x6 égal à 17% environ (x1≤x6<x5), et de préférence également dans les couches barrières 33.1 réalisées en Inₓ₄Ga₁₋ₓ₄N avec x4 égal à 17% environ (x1≤x4<x5), et émet en réponse un deuxième rayonnement lumineux de plus grande longueur d'onde, ici une lumière verte, au niveau des couches émissives 33.2 réalisées en Inₓ₅Ga₁₋ₓ₅N avec x5 égal à 25% environ.

Dans le mode de réalisation décrit précédemment, la couche d'absorption 34 et la couche tampon 32 sont distinctes des première et dernière couches barrières 33.1 de la couche d'émission 33. Cependant, en variante, elles peuvent être confondues avec ces dernières.

Par ailleurs, la structure d'émission 10 peut être formée d'un empilement de couches semiconductrices continues (comme représenté sur les fig.1A-1F). En variante, elle peut comporter une pluralité de diodes électroluminescentes distinctes les unes des autres. De plus, la structure de conversion 30 peut se présenter sous la forme d'un empilement de couches semiconductrices continues s'étendant en regard de la structure d'émission 10. En variante, elle peut se présenter sous la forme d'une pluralité de plots distincts les uns des autres, les plots étant formés par gravure localisée de l'empilement initial des couches semiconductrices 32, 33, 34. Chaque plot de conversion peut s'étendre en regard d'une ou plusieurs diodes électroluminescentes.

A ce titre, la figure 2A est une vue en coupe qui illustre schématiquement un dispositif optoélectronique 1 obtenu selon un autre mode de réalisation du procédé de fabrication. La structure d'émission 10 comporte ici plusieurs diodes électroluminescentes 2 pouvant être connectées les unes aux autres en parallèle ou en série. La structure de conversion 30 comporte plusieurs plots de conversion 35, obtenus à partir du même empilement de couches semiconductrices 32, 33, 34, disposés chacun en regard d'une diode électroluminescente 2. Ainsi, le dispositif optoélectronique comporte une matrice de pixels lumineux, chaque pixel lumineux comportant ici une unique diode électroluminescente 2 surmontée ou non d'un plot de conversion 35, les pixels pouvant être activés indépendamment les uns des autres. Dans cet exemple sont représentés trois pixels, un pixel bleu P_{B} ne comportant pas de plot de conversion 35 et deux pixels rouges P_{R} comportant chacun un plot de conversion 35.

Les diodes électroluminescentes 2 sont formées chacune d'un empilement d'une première portion 12 dopée, ici de type n, et d'une deuxième portion 14 dopée, ici de type p, entre lesquelles est située une zone active 13. Elles forment des structures en mesa sensiblement coplanaires les unes aux autres. Cette structure de diodes électroluminescentes est similaire ou identique à celle décrite dans le document EP 2 960 940 A1. Par structure en mesa, on entend une structure formée d'un empilement de portions semiconductrices situées en saillie au-dessus d'un substrat de croissance 11 (cf. fig.iA) à la suite d'une étape de gravure. Les structures en mesa sont sensiblement coplanaires dans le sens où les premières portions 12 dopées des diodes électroluminescentes sont respectivement coplanaires. Il en est de même pour les zones actives 13 et les deuxièmes portions 14 dopées.

Chaque diode électroluminescente 2 présente une première portion 12 dopée dont une surface 3 opposée à la zone active 13 est une surface par laquelle est émis le rayonnement lumineux de la diode. Les flancs latéraux de la première portion 12 dopée et de la deuxième portion 14 dopée, ainsi que ceux de la zone active 13, sont recouverts d'une couche diélectrique 41, à l'exception d'une surface de décrochement 42 de la première portion 12 dopée.

Les diodes électroluminescentes 2 sont séparées les unes des autres par des éléments latéraux 43 de connexion électrique qui s'étendent suivant l'axe Z entre les diodes. Chaque diode électroluminescente 2 est ainsi associée à un élément latéral 43 de connexion qui vient au contact électrique de la surface de décrochement 42 de la première portion 12 dopée, permettant d'appliquer un potentiel électrique déterminée à cette dernière. Cet élément latéral 43 de connexion est cependant électriquement isolé des diodes adjacentes 2 par les couches diélectriques 41 de celles-ci.

La structure d'émission 10 comporte dans cet exemple une couche 45 de raccord électrique, qui participe à former une couche support, la couche 45 permettant le contact électrique entre la puce de commande 15 d'une part, et les éléments latéraux 43 de connexion électrique et des portions 44 de connexion électrique situées au contact des deuxièmes portions 14 dopées. La couche de raccord 45 comporte ainsi des plots de connexion 46 électriquement isolés les uns des autres par un matériau diélectrique. Ainsi, la puce de commande 15 peut appliquer un potentiel électrique à l'une et/ou l'autre des diodes électroluminescentes 2, et ainsi les activer indépendamment les unes des autres.

Une couche intercalaire 47, réalisée en un matériau diélectrique transparent au premier rayonnement lumineux, recouvre ici la face supérieure des premières portions 12 dopées ainsi que les éléments latéraux 43 de connexion. Elle peut éventuellement comporter en outre une couche de planarisation. Elle peut être réalisée en un oxyde ou un nitrure de silicium (SiO₂, Si₃N₄, SiON...). La face 3 de la couche intercalaire 47 opposée aux diodes électroluminescentes 2 forme la surface de transmission 3 de la structure d'émission 10. En variante, la couche intercalaire 47 peut être une plaque transparente rapportée, réalisée en verre, par exemple en verre borosilicate, en pyrex, saphir ou autre. La plaque transparente peut être assemblée par collage.

Dans cet exemple, la structure de conversion 30 est formée de plots de conversion 35 obtenus par gravure localisée de l'empilement de couches semiconductrices 32, 33, 34 (cf. fig.iD), cet empilement ayant été assemblé à la surface de transmission 3 de la structure d'émission 10 (cf. fig.iE). La gravure peut être une gravure sèche, par exemple une gravure par plasma (RIE, ICP...).

La figure 2B est une vue en coupe qui illustre schématiquement un dispositif optoélectronique 1 obtenu selon un autre mode de réalisation du procédé de fabrication.

Ce dispositif optoélectronique 1 diffère de celui de la fig.2A notamment en ce que la structure d'émission 10 comporte des diodes électroluminescentes 2 sans la surface de décrochement 35 et pouvant être connectées en parallèle les unes aux autres. Elle comporte ainsi une couche 47 dopée selon le même type de conductivité que celui des premières portions 12, et de préférence surdopée, par exemple n+, s'étendant continûment pour contacter chacune des premières portions 12 dopées n. Ainsi, les premières portions 12 dopées peuvent être électriquement polarisées via la couche surdopée 47, et les deuxièmes portions 14 dopées peuvent l'être via les portions 44 de connexion électrique.

Ce dispositif optoélectronique 1 diffère de celui de la fig.2A également en ce que la structure de conversion 30 comporte des premiers plots 35 de conversion adaptés à convertir au moins une partie du premier rayonnement lumineux en un deuxième rayonnement lumineux, par exemple en une lumière verte, et des deuxièmes plots 36 de conversion adaptés à convertir au moins une partie du deuxième rayonnement lumineux en un troisième rayonnement lumineux, par exemple en une lumière rouge. Les premiers plots 35 de conversion reposent sur la surface de transmission 3 de la structure d'émission 10, et les deuxièmes plots 36 de conversion reposent sur la face opposée des premiers plots 35 de conversion. Chacun des premiers plots 35 et des deuxièmes plots 36 peuvent s'étendre en regard d'une ou plusieurs diodes électroluminescentes 2. Les deuxièmes plots 36 de conversion présentent une surface, dans le plan XY, inférieures ou égales à celle des premiers plots 35 de conversion sur lesquels ils reposent. Le dispositif optoélectronique 1 peut ainsi comporter différents types de plots de conversion 35, 36... adaptés à convertir la lumière incidente en une lumière de plus grande longueur d'onde.

Des modes de réalisation particuliers viennent d'être décrits. Différentes variantes et modifications apparaîtront à l'homme du métier, notamment en fonction des applications visées.

## Revendications

1. Procédé de fabrication d'un dispositif optoélectronique (1) réalisé à base de GaN, comprenant :
∘ une structure d'émission (10) comportant une zone active (13) adaptée à émettre un premier rayonnement lumineux à une première longueur d'onde (λ₁),
le procédé comportant les étapes suivantes :
i. réalisation d'une structure de croissance (20) comportant :
∘ une couche de germination (23) en Inₓ₂Ga₁₋ₓ₂N au moins partiellement relaxé, x2 étant la proportion atomique d'indium ;
ii. réalisation d'une structure de conversion (30), par croissance épitaxiale à partir de la structure de croissance (20), comportant :
∘ une couche d'émission (33), réalisée à base d'InGaN à partir de la couche de germination (23), comportant une zone active (33) adaptée à émettre un rayonnement lumineux à une deuxième longueur d'onde (λ₂) supérieure à la première longueur d'onde (λ₁), et
∘ une couche d'absorption (34), réalisée à base d'InGaN à partir de la couche d'émission (33), adaptée à absorber au moins partiellement le premier rayonnement lumineux ;
iii. report de la structure de conversion (30) sur la structure d'émission (10) de sorte que la couche d'absorption (34) est située entre la structure d'émission (10) et la couche d'émission (33) de la structure de conversion (30).

2. Procédé selon la revendication 1, dans lequel la couche d'absorption (34) est réalisée en Inₓ₆Ga₁₋ₓ₆N, la proportion atomique d'indium x6 étant choisie pour que la couche d'absorption (34) présente une énergie de bandes interdites Eg(Inₓ₆Ga₁₋ₓ₆N) inférieure à h.c/λ₁, h étant la constante de Boltzmann et c la célérité de la lumière, et λ₁ étant la première longueur d'onde.

3. Procédé selon la revendication 1 ou 2, dans lequel la couche d'émission (33) forme une zone active comportant une alternance de couches barrières (33.1) en Inₓ₄Ga₁₋ₓ₄N tel que la proportion atomique x4 soit supérieure ou égale à la proportion atomique d'indium x2, et d'au moins une couche émissive (33.2) en Inₓ₅Ga₁₋ₓ₅N de proportion atomique d'indium x5 formant un puits quantique intercalé entre deux couches barrières (33.1), la proportion atomique d'indium x4 des couches barrières (33.1) étant choisie pour qu'elles présentent une énergie de bandes interdites Eg(Inₓ₄Ga₁₋ₓ₄N) inférieure à h.c/λ₁

4. Procédé selon la revendication 3, dans lequel la zone active (13) de la structure d'émission (10) comporte au moins un puits quantique (13.2) en Inₓ₁Ga₁₋ₓ₁N de proportion atomique d'indium x1, la proportion atomique d'indium x4 étant supérieure ou égale à la proportion atomique d'indium x1 et inférieure à la proportion atomique d'indium x5.

5. Procédé selon la revendication 3 ou 4, dans lequel la zone active (13) de la structure d'émission (10) comporte au moins un puits quantique (13.2) en Inₓ₁Ga₁₋ₓ₁N de proportion atomique d'indium x1, la couche d'absorption (34) étant réalisée en Inₓ₆Ga₁₋ₓ₆N avec une proportion atomique d'indium x6 supérieure ou égale à la proportion atomique d'indium x1 et inférieure à la proportion atomique d'indium x5.

6. Procédé selon l'une quelconque des revendications 3 à 5, dans lequel la proportion atomique d'indium x5 est comprise entre 22% et 30%.

7. Procédé selon l'une quelconque des revendications 1 à 6, dans lequel la couche de germination (23) est réalisée en Inₓ₂Ga₁₋ₓ₂N avec une proportion atomique d'indium x2 comprise entre 1% et 14%.

8. Procédé selon l'une quelconque des revendications 1 à 7, dans lequel la couche de germination (23) présente un paramètre de maille égal à sa valeur naturelle à 0,75% près en compression et à 0,15% près en tension, et de préférence égal à sa valeur naturelle à ± 0,03% près.

9. Procédé selon l'une quelconque des revendications 1 à 8, dans lequel la couche d'émission (33) forme une zone active comportant une alternance de couches barrières (33.1) en Inₓ₄Ga₁₋ₓ₄N tel que la proportion atomique d'indium x4 soit supérieure ou égale à la proportion atomique d'indium x2, et d'au moins une couche émissive (33.2) en Inₓ₅Ga₁₋ₓ₅N formant un puits quantique intercalé entre deux couches barrières (33.1), dans lequel l'étape ii de réalisation de la structure de conversion (30) comporte la réalisation de :
∘ une couche tampon (32), réalisée à base d'Inₓ₃Ga₁₋ₓ₃N à partir de la couche de germination (23), configurée pour permettre une adaptation de maille entre l'Inₓ₂Ga₁₋ₓ₂N de la couche de germination (23) et l'Inₓ₄Ga₁₋ₓ₄N d'une couche barrière (33.1) de la couche d'émission (33) avec laquelle elle est destinée à être en contact.

10. Procédé selon la revendication 9, dans lequel la couche tampon (32) est formée d'une alternance de couches à base de GaN et de couches en In_{x3'}Ga_{1-x3'}N de proportion atomique d'indium x3'.

11. Procédé selon la revendication 10, dans lequel les couches en In_{x3'}Ga_{1-x3'}N présentent une proportion atomique d'indium x3' supérieure ou égale à la proportion atomique d'indium x4.

12. Procédé selon la revendication 9, dans lequel la couche tampon (32) est réalisée en Inₓ₃Ga₁₋ₓ₃N avec une proportion atomique d'indium x3 qui augmente entre la valeur x2 à l'interface avec la couche de germination (23) et la valeur x4 à l'interface avec la couche barrière (33.1) de la couche d'émission (33) au contact de la couche tampon (32).

13. Procédé selon l'une quelconque des revendications 1 à 12, dans lequel la structure de croissance (20) est formée d'un empilement d'une couche support (21), d'une couche de liaison (22) et de la couche de germination (23).

14. Procédé selon la revendication 13, dans lequel la couche de germination (23) est formée par report sur la couche de liaison (22) d'une couche en Inₓ₂Ga₁₋ₓ₂N préalablement épitaxiée à partir d'un substrat de croissance, suivie d'une séparation de la couche en Inₓ₂Ga₁₋ₓ₂N en deux parties au niveau d'une zone fragilisée suite à une implantation ionique préalable, la partie au contact de la couche de liaison (22) formant la couche de germination (23).

15. Procédé selon l'une quelconque des revendications 13 à 14, comportant, à la suite de l'étape iii de report, la suppression de la couche support (21) et de la couche de liaison (22) de la structure de croissance (20).

## Patentansprüche

1. Verfahren zur Herstellung einer auf der Basis von GaN gefertigten optoelektronischen Vorrichtung (1), welche umfasst:
o eine Emissionsstruktur (10), die einen aktiven Bereich (13) umfasst, der dazu eingerichtet ist, eine erste Lichtstrahlung mit einer ersten Wellenlänge (λ₁) auszusenden,
wobei das Verfahren die folgenden Schritte umfasst:
i. Herstellung einer Wachstumsstruktur (20), welche umfasst:
∘ eine Keimschicht (23) aus Inₓ₂Ga₁₋₋ₓ₂N, die wenigstens teilweise entspannt ist, wobei x2 der Atomanteil von Indium ist;
ii. Herstellung, durch epitaktisches Aufwachsen auf der Wachstumsstruktur (20), einer Konversionsstruktur (30), welche umfasst:
∘ eine auf der Basis von InGaN aus der Keimschicht (23) hergestellte Emissionsschicht (33), die einen aktiven Bereich (33) umfasst, der dazu eingerichtet ist, eine Lichtstrahlung mit einer zweiten Wellenlänge (λ₂) auszusenden, die größer als die erste Wellenlänge (λ₁) ist, und
∘ eine auf der Basis von InGaN aus der Emissionsschicht (33) hergestellte Absorptionsschicht (34), die dazu eingerichtet ist, die erste Lichtstrahlung wenigstens teilweise zu absorbieren;
iii. Aufbringung der Konversionsstruktur (30) auf die Emissionsstruktur (10), derart, dass sich die Absorptionsschicht (34) zwischen der Emissionsstruktur (10) und der Emissionsschicht (33) der Konversionsstruktur (30) befindet.

2. Verfahren nach Anspruch 1, wobei die Absorptionsschicht (34) aus Inₓ₆Ga₁₋₋ₓ₆N hergestellt ist, wobei der Atomanteil von Indium x6 so gewählt ist, dass die Absorptionsschicht (34) eine Bandlückenenergie Eg(Inₓ₆Ga₁₋₋ₓ₆N) aufweist, die kleiner als h.c/λ₁ ist, wobei h die Boltzmann-Konstante und c die Lichtgeschwindigkeit ist und λ₁ die erste Wellenlänge ist.

3. Verfahren nach Anspruch 1 oder 2, wobei die Emissionsschicht (33) einen aktiven Bereich bildet, der eine wechselnde Folge von Sperrschichten (33.1) aus Inₓ₄Ga₁₋₋ₓ₄N, wobei der Atomanteil x4 größer oder gleich dem Atomanteil von Indium x2 ist, und von wenigstens einer emittierenden Schicht (33.2) aus Inₓ₅Ga₁₋₋ₓ₅N mit einem Atomanteil von Indium x5, die einen zwischen zwei Sperrschichten (33.1) angeordneten Quantentopf bildet, umfasst, wobei der Atomanteil von Indium x4 der Sperrschichten (33.1) so gewählt ist, dass sie eine Bandlückenenergie Eg(Inₓ₄Ga₁₋₋ₓ₄N) aufweisen, die kleiner als h.c/λ₁ ist.

4. Verfahren nach Anspruch 3, wobei der aktive Bereich (13) der Emissionsstruktur (10) wenigstens einen Quantentopf (13.2) aus Inₓ₁Ga₁₋₋ₓ₁N mit einem Atomanteil von Indium x1 umfasst, wobei der Atomanteil von Indium x4 größer oder gleich dem Atomanteil von Indium x1 und kleiner als der Atomanteil von Indium x5 ist.

5. Verfahren nach Anspruch 3 oder 4, wobei der aktive Bereich (13) der Emissionsstruktur (10) wenigstens einen Quantentopf (13.2) aus Inₓ₁Ga₁₋₋ₓ₁N mit einem Atomanteil von Indium x1 umfasst, wobei die Absorptionsschicht (34) aus Inₓ₆Ga₁₋₋ₓ₆N mit einem Atomanteil von Indium x6 hergestellt ist, der größer oder gleich dem Atomanteil von Indium x1 und kleiner als der Atomanteil von Indium x5 ist.

6. Verfahren nach einem der Ansprüche 3 bis 5, wobei der Atomanteil von Indium x5 zwischen 22 % und 30 % liegt.

7. Verfahren nach einem der Ansprüche 1 bis 6, wobei die Keimschicht (23) aus Inₓ₂Ga₁₋₋ₓ₂N mit einem Atomanteil von Indium x2 zwischen 1 % und 14 % hergestellt ist.

8. Verfahren nach einem der Ansprüche 1 bis 7, wobei die Keimschicht (23) einen Gitterparameter aufweist, der unter Druckbeanspruchung bis auf 0,75 % genau und unter Zugbeanspruchung bis auf 0,15 % genau gleich seinem natürlichen Wert ist und vorzugsweise bis auf ±0,03 % genau gleich seinem natürlichen Wert ist.

9. Verfahren nach einem der Ansprüche 1 bis 8, wobei die Emissionsschicht (33) einen aktiven Bereich bildet, der eine wechselnde Folge von Sperrschichten (33.1) aus Inₓ₄Ga₁₋₋ₓ₄N, wobei der Atomanteil von Indium x4 größer oder gleich dem Atomanteil von Indium x2 ist, und von wenigstens einer emittierenden Schicht (33.2) aus Inₓ₅Ga₁₋₋ₓ₅N, die einen zwischen zwei Sperrschichten (33.1) angeordneten Quantentopf bildet, umfasst, wobei Schritt ii der Herstellung der Konversionsstruktur (30) die Herstellung umfasst von:
∘ einer auf der Basis von Inₓ₃Ga₁₋₋ₓ₃N aus der Keimschicht (23) hergestellten Pufferschicht (32), die die dafür ausgelegt ist, eine Gitteranpassung zwischen dem Inₓ₂Ga₁₋₋ₓ₂N der Keimschicht (23) und dem Inₓ₄Ga₁₋₋ₓ₄N einer Sperrschicht (33.1) der Emissionsschicht (33), mit welcher sie in Kontakt kommen soll, zu ermöglichen.

10. Verfahren nach Anspruch 9, wobei die Pufferschicht (32) von einer wechselnden Folge von Schichten auf der Basis von GaN und von Schichten aus In_{x3'}Ga_{1--x3'}N mit einem Atomanteil von Indium x3' gebildet wird.

11. Verfahren nach Anspruch 10, wobei die Schichten aus In_{x3'}Ga_{1--x3'}N einen Atomanteil von Indium x3' aufweisen, der größer oder gleich dem Atomanteil von Indium x4 ist.

12. Verfahren nach Anspruch 9, wobei die Pufferschicht (32) aus Inₓ₃Ga₁₋₋ₓ₃N mit einem Atomanteil von Indium x3 hergestellt ist, der sich zwischen dem Wert x2 an der Grenzfläche mit der Keimschicht (23) und dem Wert x4 an der Grenzfläche mit der Sperrschicht (33.1) der Emissionsschicht (33), die sich in Kontakt mit der Pufferschicht (32) befindet, erhöht.

13. Verfahren nach einem der Ansprüche 1 bis 12, wobei die Wachstumsstruktur (20) von einem Stapel aus einer Trägerschicht (21), einer Verbindungsschicht (22) und der Keimschicht (23) gebildet wird.

14. Verfahren nach Anspruch 13, wobei die Keimschicht (23) durch Aufbringung, auf die Verbindungsschicht (22), einer Schicht aus Inₓ₂Ga₁₋₋ₓ₂N gebildet wird, die zuvor auf einem Wachstumssubstrat epitaxiert wurde, gefolgt von einer Trennung der Schicht aus Inₓ₂Ga₁₋₋ₓ₂N in zwei Teile an einem geschwächten Bereich im Anschluss an eine vorherige Ionenimplantation, wobei der mit der Verbindungsschicht (22) in Kontakt befindliche Teil die Keimschicht (23) bildet.

15. Verfahren nach einem der Ansprüche 13 bis 14, welches im Anschluss an den Schritt iii. der Aufbringung die Entfernung der Trägerschicht (21) und der Verbindungsschicht (22) aus der Wachstumsstruktur (20) umfasst.

## Claims

1. Method of fabricating an optoelectronic device (1) produced on the basis of GaN, comprising:
∘ an emission structure (10) comprising an active zone (13) adapted for emitting a first light at a first wavelength (λ₁),
the method comprising the following steps:
i. producing a growth structure (20) comprising:
∘ a nucleation layer (23) of Inₓ₂Ga₁₋ₓ₂N at least partially relaxed, x2 being the atomic proportion of indium;
ii. producing a conversion structure (30), by epitaxial growth starting from the growth structure (20), comprising:
∘ an emission layer (33), produced on the basis of InGaN starting from the nucleation layer (23), comprising an active zone (33) adapted for emitting light at a second wavelength (λ₂) higher than the first wavelength (λ₁), and
∘ an absorption layer (34), produced on the basis of InGaN starting from the emission layer (33), adapted for absorbing the first light at least partially;
iii. transfer of the conversion structure (30) onto the emission structure (10) in such a way that the absorption layer (34) is located between the emission structure (10) and the emission layer (33) of the conversion structure (30).

2. Method according to Claim 1, in which the absorption layer (34) is made of Inₓ₆Ga₁₋ₓ₆N, the atomic proportion of indium x6 being selected so that the absorption layer (34) has an energy bandgap Eg(Inₓ₆Ga₁₋ₓ₆N) less than h.c/λ₁, h being the Boltzmann constant and c the speed of light, and λ₁ being the first wavelength.

3. Method according to Claim 1 or 2, in which the emission layer (33) forms an active zone comprising an alternation of barrier layers (33.1) of Inₓ₄Ga₁₋ₓ₄N such that the atomic proportion x4 is greater than or equal to the atomic proportion of indium x2, and at least one emitting layer (33.2) of Inₓ₅Ga₁₋ₓ₅N with an atomic proportion of indium x5 forming a quantum well inserted between two barrier layers (33.1), the atomic proportion of indium x4 of the barrier layers (33.1) being selected so that they have an energy bandgap Eg(Inₓ₄Ga₁₋ₓ₄N) less than h.c/λ₁.

4. Method according to Claim 3, in which the active zone (13) of the emission structure (10) comprises at least one quantum well (13.2) of Inₓ₁Ga₁₋ₓ₁N with an atomic proportion of indium x1, the atomic proportion of indium x4 being greater than or equal to the atomic proportion of indium x1 and less than the atomic proportion of indium x5.

5. Method according to Claim 3 or 4, in which the active zone (13) of the emission structure (10) comprises at least one quantum well (13.2) of Inₓ₁Ga₁₋ₓ₁N with an atomic proportion of indium x1, the absorption layer (34) being made of Inₓ₆Ga₁₋ₓ₆N with an atomic proportion of indium x6 greater than or equal to the atomic proportion of indium x1 and less than the atomic proportion of indium x5.

6. Method according to any one of Claims 3 to 5, in which the atomic proportion of indium x5 is between 22% and 30%.

7. Method according to any one of Claims 1 to 6, in which the nucleation layer (23) is made of Inₓ₂Ga₁₋ₓ₂N with an atomic proportion of indium x2 between 1% and 14%.

8. Method according to any one of Claims 1 to 7, in which the nucleation layer (23) has a lattice parameter equal to its natural value to within 0.75% in compression and to within 0.15% in tension, and preferably equal to its natural value to within ±0.03%.

9. Method according to any one of Claims 1 to 8, in which the emission layer (33) forms an active zone comprising an alternation of barrier layers (33.1) of Inₓ₄Ga₁₋ₓ₄N such that the atomic proportion of indium x4 is greater than or equal to the atomic proportion of indium x2, and at least one emitting layer (33.2) of Inₓ₅Ga₁₋ₓ₅N forming a quantum well inserted between two barrier layers (33.1), in which step ii of production of the conversion structure (30) comprises production of:
∘ a buffer layer (32), produced on the basis of Inₓ₃Ga₁₋ₓ₃N starting from the nucleation layer (23), configured to allow lattice adaptation between the Inₓ₂Ga₁₋ₓ₂N of the nucleation layer (23) and the Inₓ₄Ga₁₋ₓ₄N of a barrier layer (33.1) of the emission layer (33) with which it is intended to be in contact.

10. Method according to Claim 9, in which the buffer layer (32) is formed of an alternation of layers based on GaN and of layers of In_{x3'}Ga_{1-x3'}N with an atomic proportion of indium x3'.

11. Method according to Claim 10, in which the layers of In_{x3'}Ga_{1-x3'}N have an atomic proportion of indium x3' greater than or equal to the atomic proportion of indium x4.

12. Method according to Claim 9, in which the buffer layer (32) is made of Inₓ₃Ga₁₋ₓ₃N with an atomic proportion of indium x3 that increases between the value x2 at the interface with the nucleation layer (23) and the value x4 at the interface with the barrier layer (33.1) of the emission layer (33) in contact with the buffer layer (32).

13. Method according to any one of Claims 1 to 12, in which the growth structure (20) is formed of a stack of a supporting layer (21), a binding layer (22) and the nucleation layer (23).

14. Method according to Claim 13, in which the nucleation layer (23) is formed by transfer, onto the binding layer (22), of a layer of Inₓ₂Ga₁₋ₓ₂N grown epitaxially beforehand starting from a growth substrate, followed by separation of the layer of Inₓ₂Ga₁₋ₓ₂N into two parts at the level of a zone weakened following prior ion implantation, the part in contact with the binding layer (22) forming the nucleation layer (23).

15. Method according to any one of Claims 13 to 14, comprising, following the transfer step iii, removal of the supporting layer (21) and of the binding layer (22) from the growth structure (20).
